# EUROPEAN PATENT SPECIFICATION

(11) **EP 2 193 033 B1**
(45) Date of publication and mention of the grant of the patent: **07.11.2012**
(21) Application number: 07804975.6
(22) Date of filing: 25.09.2007
(51) Int. Cl.: B41M 5/26, B41M 5/025, B41M 5/34, G02F 1/133, G02F 1/135, G03F 7/20, B41M 5/382

(54) **BIDIRECTIONAL THERMAL TRANSFER IMAGING**
BIDIREKTIONALES THERMOTRANSFER BEBILDERUNGSVERFAHREN
PROCEDE D'IMPRESSION PAR TRANSFERT THERMIQUE BIDIRECTIONNEL

(43) Date of publication of application: 09.06.2010
(73) Proprietor: Kodak Graphic Communications Canada Company, Burnaby BC V5G 4M1 (CA)
(72) Inventor: WEINKAM, Daniel, Coquitlam British Columbia V3K 2A4 (CA); SHINKODA, Ichiro, Vancouver British Columbia V6M 2G2 (CA)
(74) Representative: Weber, Etienne Nicolas
(86) International application number: PCT/IB2007/002786
(87) International publication number: WO 2009/040592

(56) References cited:
- EP-A2- 0 710 005
- EP-A2- 1 376 715
- US-A- 5 745 153
- US-A1- 2003 011 672

## Description

### TECHNICAL FIELD

The invention relates to imaging systems and to methods for forming images. The invention may be applied to fabricating color filters for electronic displays, for example.

### BACKGROUND

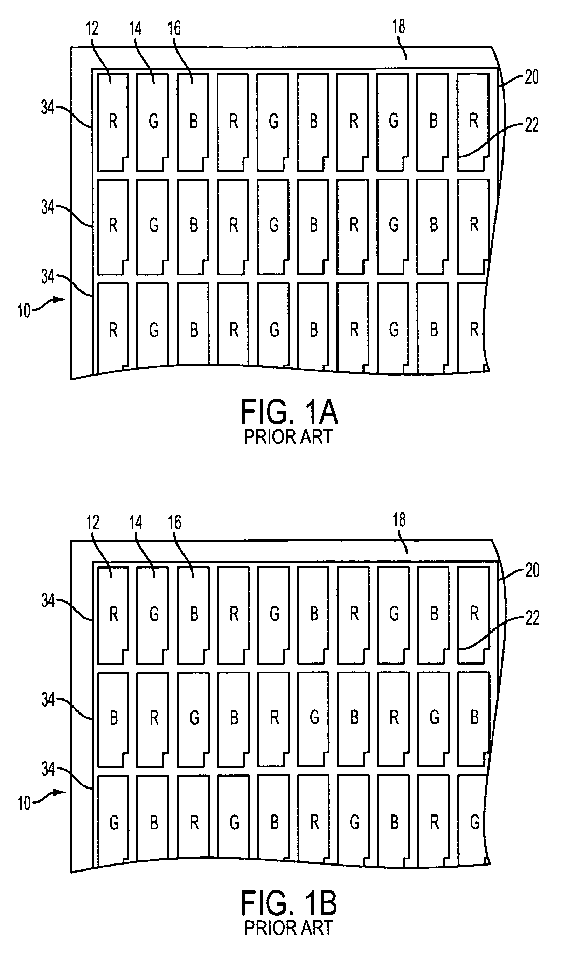

Color filters used in display panels typically include a pattern comprising a plurality of color features. The color features may include patterns of red, green and/or blue color features, for example. Color filters may be made with color features of other colors. The color features may be arranged in any of various suitable configurations. Prior art stripe configurations have alternating columns of red, green and blue color features as shown in Figure 1A.

Figure 1A shows a portion of a prior art "stripe configuration" color filter 10 having a plurality of red (R), green (G) and blue (B) color features 12, 14 and 16 respectively formed in alternating columns across a receiver element 18. Color features 12, 14 and 16 are outlined by portions of a color filter matrix 20 (also referred to as matrix 20). The columns can be imaged in elongated stripes that are subdivided by matrix cells 34 (also referred to as cells 34) into individual color features 12, 14 and 16. TFT transistors on the associated LCD panel (not shown) may be masked by areas 22 of matrix 20.

The stripe configuration shown in Figure 1A illustrates one example configuration of color filter features. Color filters may have other configurations. Mosaic configurations have the color features that alternate in both directions (e.g. along columns and rows) such that each color feature resembles an "island". Delta configurations (not-shown) have groups of red, green and blue color features arranged in a triangular relationship to each other. Mosaic and delta configurations are examples of "island" configurations. Figure 1B shows a portion of a prior art color filter 10 arranged in a mosaic configuration in which color features 12, 14 and 16 are arranged in columns and alternate both across and along the columns.

Other color filter configurations are also known in the art. Whereas the illustrated examples described above show patterns of rectangular shaped color filter elements, other patterns including other shaped features are also known.

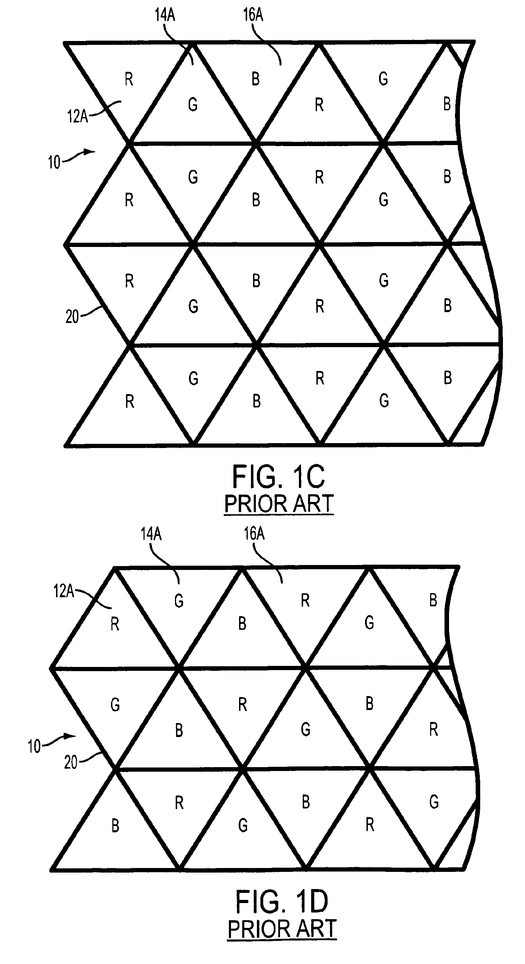

Figure 1C shows a portion of a prior art color filter 10 with a configuration of red (R), green (G) and blue (B) triangular shaped color features 12A, 14A and 16A. As illustrated in Figure 1C, each of the respective color features are arranged along columns and are aligned with matrix 20.

Figure 1D shows a portion of a prior art color filter 10 with a configuration of red (R), green (G) and blue (B) triangular shaped color features 12A, 14A and 16A. As illustrated in Figure 1D, each of the respective color features alternate along the columns and rows of color filter 10. As shown in Figures 1C and 1D, color features 12A, 14A and 16A can have different orientations within a given row or column.

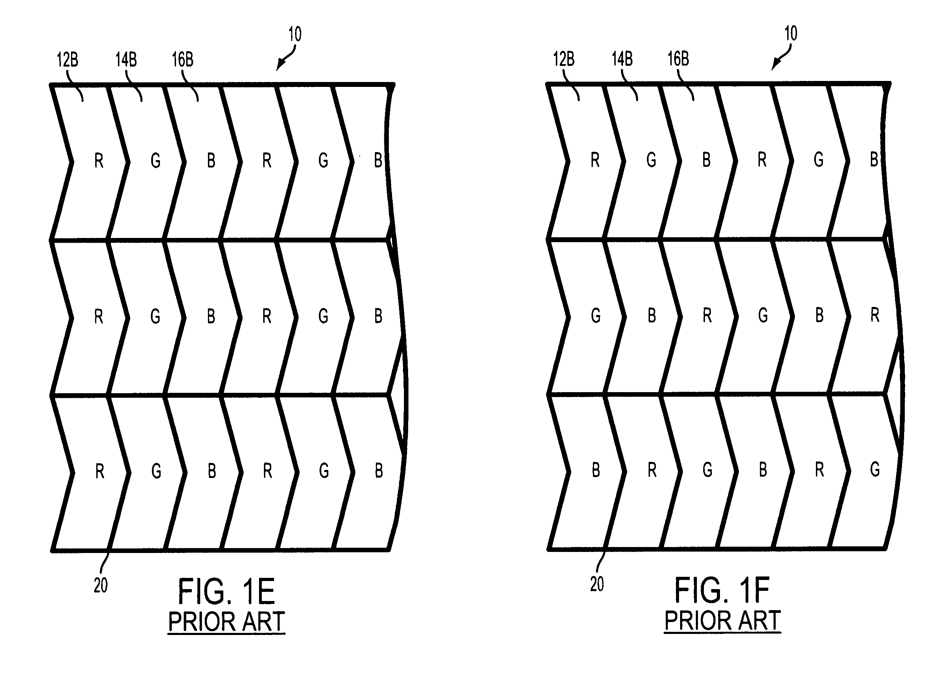

Figure 1E shows a portion of a prior art color filter 10 that includes a configuration of red (R), green (G) and blue (B) chevron shaped color features 12B, 14B and 16B. As illustrated in Figure 1E, each of the respective color features are arranged along columns and are aligned with matrix 20. Color features 12B, 14B and 16B are formed from stripes that bend from side to side and are outlined by portions of a color filter matrix 20.

Figure 1F shows a portion of a prior art color filter 10 that includes a configuration of red (R), green (G) and blue (B) chevron shaped color features 12B, 14B and 16B. As illustrated in Figure 1F, each of the respective color features alternate along the columns and rows of color filter 10.

The shape and configuration of a color filter feature can be selected to provide desired color filter attributes such as a better color mix or enhanced viewing angles.

Various imaging methods are known in the art and can be used to form various features on media. For example, laser-induced thermal transfer processes have been proposed for use in the fabrication of displays, and in particular color filters. In some manufacturing techniques, when laser-induced thermal transfer processes are used to produce a color filter, a color filter substrate also known as a receiver element is overlaid with a donor element that is then image-wise exposed to selectively transfer a colorant from the donor element to the receiver element. Preferred exposure methods use radiation beams such as laser beams to induce the transfer of the colorant to the receiver element. Diode lasers are particularly preferred for their low cost and small size.

Laser induced "thermal transfer" processes include: laser induced "dye transfer" processes, laser-induced "melt transfer" processes, laser-induced "ablation transfer" processes, and laser-induced "mass transfer" processes. Colorants transferred during laser-induced thermal transfer processes include suitable dye-based or pigment-based compositions. Additional elements such as one or more binders may be transferred.

Some conventional laser imaging systems emit a limited number of radiation beams. Other conventional systems reduce the time required to complete images by controlling hundreds of individually-modulated imaging channels to emit corresponding radiation beams. Imaging heads with large numbers of such "channels" are available. For example, a SQUAREspot® model thermal imaging head manufactured by Kodak Graphic Communications Canada Company, British Columbia, Canada has several hundred independent channels. Each channel can have power in excess of 25 mW. An array of imaging channels can be controlled to write a series of image swaths which are arranged to form a continuous image.

Radiation beams are scanned along a scan path to form various images. In some cases, radiation beams are scanned in a first direction during a first scan and are scanned in a second direction during a second scan such that the second direction is different than the first direction. Bidirectional imaging refers to the case in which the second direction is opposite to the first direction. Bidirectional imaging techniques can be used enhance the productivity of the imaging process since the start of each scan need not occur at a common position.

The visual quality of a formed image can be an important consideration in the selection of a particular imaging process. In applications such as laser-induced thermal transfer of color filter features, the quality of the formed color filter is dependant on imaging features that have substantially the same visual characteristics. For example, one particular visual characteristic can include density (e.g. optical density or color density). Density variations among the imaged color features can lead to objectionable image artifacts. Image artifacts can include banding or color variations in imaged features.

Other image artifacts can include the formation of features with rough edges. In U.S. Pat. 6,242,140, Kwon et al describe a method for manufacturing a color filter by thermal transfer using a complex laser beam. Kwon et al. describe that the complex laser beam can be formed of unit laser beams having different energy distributions. Kwon et al. describe that the complex laser beam can comprise a plurality of unit laser beams having a high energy intensity at the edges, and a unit laser beam having a high energy intensity at the center. Kwon et al. describe that such a complex laser beam can be created to increase the slope of the energy distribution at a threshold energy which is the minimum energy transfer, such that the boundary is distinctly transferred, resulting in a image having excellent edge characteristics. However, this reference does not address the problem of image variations from swath to swath caused by bidirectional scanning.

In U.S. Pat. 6,025,860, Rosenfeld et al. describe a digital decorating system for transferring a selected image to a surface of an article. The system includes a thermal printhead that includes a plurality of energizable heater elements constructed to deliver heat to a thermal line of pixels on a surface of the printhead. Rosenfeld et al. describe that a microcontroller can be used to control various systems to form a two dimensional image. Rosenfeld et al. describe that the controller can classify the pixels corresponding to the image into perimeter pixels and interior pixels and control energy levels delivered to produce heat at the perimeter pixels and interior pixels. Rosenfeld et al. describes an edge enhancement technique in which a microcontroller "looks" for initial transfer pixels and generates higher energy levels for the pixels that form an edge. The edge pixels are controlled to have a higher temperature than the interior pixels creating a temperature gradient at the edge between heated and unheated regions. Rosenfeld et al. describe that the temperature gradient enables the transferred material to separate form the material remaining on the foil in a well defined manner. Rosenfeld et al. also describe a "line smoothing" routine that eliminates a stair-step appearance of lines or edges that lie diagonally to the direction of thermal transfer motion. Rosenfeld et al. describe that a low level of energy is applied to a pixel lying outwardly of an edge pixel (i.e., a pixel not assigned as part of the computer generated image). Rosenfeld et al. describe that a decreased thermal gradient is produced at the edges which produces less precisely defined lines that effectively smooth the line that would otherwise have a stair step appearance. While this reference addresses the smoothing of edges, it does not address the problem of image variations from swath to swath caused by bidirectional scanning.

In U.S. Pat. 5,321,426, Baek et al. describe a printhead arrangement which includes two outboard "dummy" channels. The printhead is used in a thermal dye transfer process. The dummy channels produce dummy scan lines which are not used for actual writing, but rather for preheating and postheating inner scan lines to help alleviate banding. Baek et al. describe that the dummy channels can be operated to write at a constant laser power level near the threshold point of dye transfer to help reduce density variations between swaths. However, it does not provide a solution to the problem of image variations from swath to swath caused by bidirectional scanning.
In U.S. 20030/011672 a technique is disclosed for marking pixels with a scanned beam. Two workpieces may be marked by two-directional scanning.
EP 1 376 715 discloses a method for depositing an OLED emissive layer. A movable light beam heats a donor element and causes the transfer of emissive material.

Artifacts such as banding can be difficult to correct and typically require the establishment of imaging parameters that lead to formation of adjacent swaths that include substantially the same characteristics. It has been noted however by the present inventors that when the same imaging parameters are employed to scan radiation beams both in a first direction during a first scan and a second direction different from the first direction during a second scan, various image artifacts can still arise. This can impact the usefulness of imaging methods such as bidirectional imaging.

There remains a need for effective and practical imaging methods and systems that permit making high-quality images of features while scanning in multiple scan directions.

There remains a need for effective and practical imaging methods and systems that permit making high-quality images of features in a bidirectional imaging system.

There remains a need for imaging methods that can be used to reduce differences between portions of an image formed by radiation beams scanned in a first direction during a first scan and additional portions of the image formed by radiation beams scanned in a second direction opposite to the first direction during a second scan.

There remains a need for improved imaging methods that can form a plurality of features with substantially the same characteristics while scanning in opposite scan directions.

### SUMMARY OF THE INVENTION

The present invention relates to a method for forming an image on a media while the media is moved relative to an imaging head. The media can include a pattern of registration sub-regions, such as, for example, a matrix. The image can include one or more patterns of features, such as color features for a color filter or colored illumination sources as part of an organic light emitting diode display. The one or more patterns of features can be registered with the pattern of registration sub-regions. The features could be island features where each feature of a first plurality of features of a first color is separated from each other feature of the first color by a feature of a different color. The features can be stripes which may or may not be interrupted in one or more directions. The edges of the features can be skewed with respect to an arrangement direction of the imaging channels.

The images can be formed by a laser-induced thermal transfer process such as a laser-induced dye-transfer process, a laser induced mass transfer process or by other means of transferring a material from a donor element to a receiver element.

The imaging method can include operating an imaging head to emit a plurality of independently-controllable radiation beams while scanning over media to form an image on the media. Each channel is capable of emitting radiation beams. A radiation beam is emitted every time the channel is turned on. Thus, as a channel is turned on and off, each time the channel is turned on, a new radiation beam is emitted from that channel.

An imaging channel of the imaging head can be operated to emit a radiation beam having a first intensity while scanning in a first direction over the media during a first scan and to emit a radiation beam having a second intensity while scanning in a second direction over the media during a second scan. The second direction is opposite to the first direction and the second intensity is different from the first intensity. A third radiation beam having a third intensity can form a third pixel. This radiation beam can have an intensity greater than the first and second intensities.

A first pixel can be formed with the radiation beam having the first intensity during the first scan, and a second pixel can be formed with the radiation beam having the second intensity during the second scan. The first and second pixels can be formed with different exposures. The first intensity can be greater or less than the second intensity. The radiation beam having the first intensity can form an exposure that is different than the exposure formed by the radiation beam having the second intensity. Either one or both of these exposures can be above or below the exposure threshold of the media and can be greater than the exposure which occurs due to the leakage intensity when the imaging channel is operated to not emit a radiation beam.

The imaging head can include a light valve and a channel of the light valve can be attenuated to make the second intensity different from the first intensity. In another embodiment, the light valve channel can be pulse width modulated to make the second intensity different from the first intensity. In yet another embodiment, the power provided to the imaging channel can be varied to make the second intensity different from the first intensity. These methods of varying the intensity can be combined and used simultaneously.

The first pixel can form a part of an edge portion or an interior portion of a feature. Similarly, the second pixel can form part of an edge portion or an interior portion of the feature or an additional feature. An edge portion can extend in a direction which intersects the scan direction or can extend in a direction which is parallel to the scan direction. In one embodiment, the imaging method includes operating an imaging channel of an imaging head to emit a plurality of radiation beams while scanning over media. Intensity information associated with the imaging channel is maintained which specifies a first intensity to set for a radiation beam in the event that the radiation beam is emitted while scanning over the media in a first direction, and specifying a second intensity that is different from the first intensity to set for the radiation beam in the event that the radiation beam is emitted while scanning over the media in a second, opposite direction. The direction of the scan is determined and the imaging channel is controlled according to the intensity information to emit the radiation beam with the intensity corresponding to the determined direction.

In one embodiment, the intensity information specifies the first intensity in the event that the radiation beam is required to form a first pixel on the media while scanning in the first direction, and specifies the second intensity in the event that the radiation beam is required to form a second pixel on the media while scanning in the second direction. The method includes determining if the first pixel is to be formed on the media while scanning in the first direction and determining if the second pixel is to be formed on the media while scanning in the second direction. The imaging channel is controlled to emit the radiation beam to form either the first pixel or the second pixel.

The intensity information can specify the first intensity in the event that the first pixel is an edge pixel, and can specify the second intensity in the event that the second pixel is an edge pixel. The method can include determining if either, or both, of the first pixel and the second pixel are edge pixels. The pixels can be formed with exposures which are different from one another. Each of the intensities can be less than or greater than a level sufficient to create an exposure greater than or equal to an exposure threshold of the media.

In one embodiment, an imaging channel of an imaging head is operated to emit a plurality of radiation beams while scanning over media. First intensity information associated with the imaging channel is maintained. The first intensity information specifies a first intensity to set for a first radiation beam in the event that the first radiation beam is scanned over the media in a first direction. Second intensity information associated with the imaging channel is maintained. The second intensity information specifies a second intensity different from the first intensity to set for a second radiation beam in the event that the second radiation beam scanned over the media in a second direction opposite to the first direction. A determination is made when the first radiation beam is to be scanned in the first direction and the intensity of the first radiation beam is set according to the first intensity information. A determination is made when the second radiation beam is to be scanned in the second direction and the intensity of the second radiation beam is set according to the second intensity information.

In another embodiment, an imaging method can include operating an imaging head to emit a plurality of independently controllable radiation beams while bidirectionally scanning over media to form an image on the media. While scanning over the media during a first scan, an imaging channel of the imaging head can be controlled to emit a radiation beam having a first intensity, the first intensity corresponding to an intensity value selected from a first set of two or more intensity values. While scanning over the media during a second scan, the imaging channel of the imaging head can be controlled to emit a radiation beam having a second intensity, the second intensity corresponding to an intensity value selected from a second set of two or more intensity values. At least one intensity value of the first set is different from at least one intensity value of the second set. One or more pixels can be formed with at least one of the radiation beams having the first intensity and one or more pixels can be formed with the radiation beam having the second intensity.

In one embodiment, a plurality of pixels is formed during the first scan. A first pixel of the plurality of pixels is formed by operating the imaging channel to emit the radiation beam having the first intensity and a second pixel of the plurality of pixels is formed by operating the imaging channel to emit a radiation beam with a third intensity. The third intensity corresponds to an additional intensity value selected from the first set. The first set may or may not include at least one intensity value corresponding to a below-threshold intensity. The method may include determining if the first pixel corresponds to an edge portion of a feature formed on the media and the first intensity may be boosted for this edge portion.

A program product can be used to carry out the various embodiments of the invention. For example, a program product carrying a set of computer-readable signals can be used which includes instructions which, when executed by a controller, cause the controller to operate an imaging head to emit a plurality of independently-controllable radiation beams while scanning over media to form an image on the media. The program product can operate an imaging channel of the imaging head to emit a radiation beam having a first intensity while scanning in a first direction over the media during a first scan. The program product can operate the imaging channel to emit a radiation beam having a second intensity while scanning in a second direction over the media during a second scan. The second direction is opposite to the first direction and the second intensity is different from the first intensity.

### BRIEF DESCRIPTION OF THE DRAWINGS

Embodiments and applications of the invention are illustrated by the attached non-limiting drawings. The attached drawings are for purposes of illustrating the concepts of the invention and may not be to scale.

Figure 1A is a plan view of a portion of a prior art color filter;

Figure 1B is a plan view of a portion of another prior art color filter;

Figure 1C is a plan view of a portion of a prior art filter including triangular shaped features;

Figure 1D is a plan view of a portion of another prior art filter including triangular shaped features;

Figure 1E is a plan view of a portion of a prior art filter including chevron shaped features;

Figure 1F is a plan view of a portion of another prior art filter including chevron shaped features;

Figure 2 is a schematic representation of a multi-channel head conventionally imaging a pattern of features onto imageable media during a plurality of scans;

Figure 3 is a schematic perspective view of the optical system of an example prior art multi-channel imaging head;

Figure 4A is a is a schematic view of apparatus forming a first portion of an image during a first scan as per an example embodiment of the invention;

Figure 4B is a is a schematic view of the apparatus of Figure 4A forming a second portion of the image during a second scan;

Figure 5 is flow chart representing a method practiced as per an example embodiment of the invention;

Figure 6 is a schematic block diagram illustrating a logic used by a light valve driver system as per an example embodiment of the invention;

Figure 7 is a schematic block diagram illustrating a logic used by a light valve driver system as per an example embodiment of the invention: and

Figure 8 shows a photograph comparing a media scanned bidirectionally and unidirectionally

### DETAILED DESCRIPTION

Throughout the following description specific details are presented to provide a more thorough understanding to persons skilled in the art. However, well-known elements may not have been shown or described in detail to avoid unnecessarily obscuring the disclosure. Accordingly, the description and drawings are to be regarded in an illustrative, rather than a restrictive, sense.

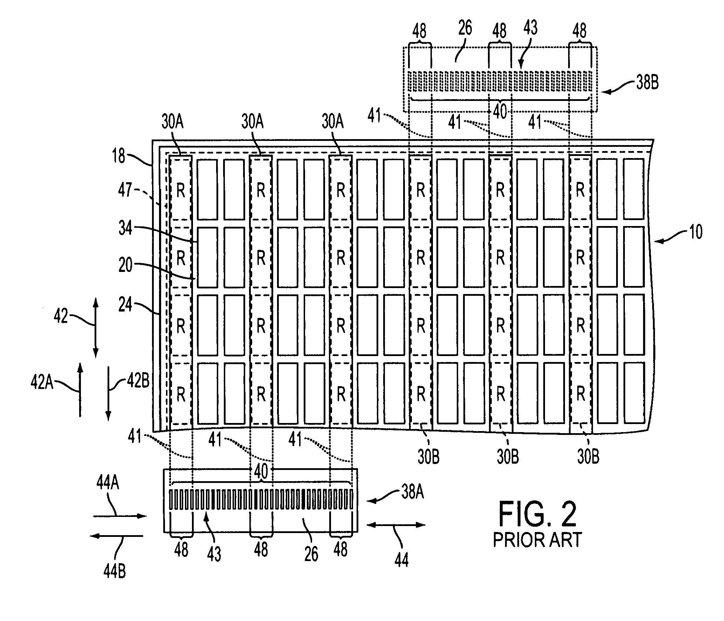

Figure 2 shows a conventional laser-induced thermal transfer process being used to fabricate a color filter 10. An imaging head 26 is provided to transfer image-forming material (not shown) from a donor element 24 to an underlying receiver element 18. Donor element 24 is shown as being smaller than receiver element 18 for the purposes of clarity only. Donor element 24 may overlap one or more portions of receiver element 18 as may be required. Imaging head 26 can include one or more imaging channels. In this case, imaging head includes an arrangement (i.e. channel array 43) of individually addressable channels 40.

Receiver element 18 can include a registration region with which it is desired to form images of one or more features in substantial alignment. Receiver element 18 can include a pattern of registration sub-regions with which it is desired to form images of one or more features in substantial alignment. In this case, receiver element 18 includes a registration region 47 (schematically represented in large broken lines). In this case, registration region 47 includes a color filter matrix 20. Matrix 20 is an example of a pattern of registration sub-regions. Although a laser-induced thermal transfer process could be used to form matrix 20 on receiver element 18, matrix 20 is typically formed by lithographic techniques.

Donor element 24 includes an image-forming material (not shown) that can be image-wise transferred onto the receiver element 18 when radiation beams emitted by imaging head 26 are scanned across donor element 24. Red, green and blue portions of filter 10 are typically imaged in separate imaging steps; each imaging step involving replacing the preceding color donor element with the next color donor element to be imaged. Each of the red, green and blue features of the filter is typically transferred to receiver element 18 in substantial alignment with a corresponding matrix cell 34. After the color features have been transferred, the imaged color filter may be subjected to one or more additional process steps, such as an annealing step, for example, to change one or more physical properties (e.g. hardness) of the imaged color features.

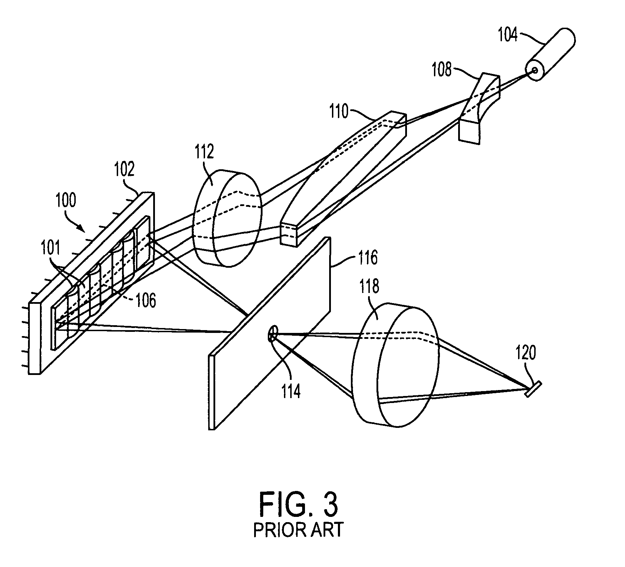

An example of an illumination system employed by a conventional laser-based multi-channel imaging process is schematically shown in Figure 3. A spatial light modulator or light valve is used to create a plurality of imaging channels. In the illustrated example, linear light valve array 100 includes a plurality of deformable mirror elements 101 fabricated on a semi-conductor substrate 102. Mirror elements 101 are individually addressable. Mirror elements 101 can be micro-electro-mechanical (MEMS) elements, such as deformable mirror micro-elements, for example. A laser 104 can generate an illumination line 106 on light valve 100 using an anamorphic beam expander comprising cylindrical lenses 108 and 110. Illumination line 106 is laterally spread across the plurality of elements 101 so that each of the mirror elements 101 is illuminated by a portion of illumination line 106. U.S. Patent 5,517,359 to Gelbart describes a method for forming an illumination line.

A lens 112 typically focuses laser illumination through an aperture 114 in an aperture stop 116 when elements 101 are in their un-actuated state. Light from actuated elements is blocked by aperture stop 116. A lens 118 images light valve 100 to form a plurality of individual image-wise modulated beams 120, which can be scanned over the area of a substrate to form an imaged swath. Each of the beams is controlled by one of the elements 101. Each element 101 corresponds to an imaging channel of a multi-channel imaging head.

Each of the beams is operable for imaging, or not imaging, an "image pixel" on the imaged receiver element in accordance with the driven state of the corresponding element 101. That is, when required to image a pixel in accordance with the image data, a given element 101 is driven to produce a corresponding radiation beam with an intensity magnitude and duration suitable for forming a pixel image on the substrate. When required not to image a pixel in accordance with the image data, a given element 101 is driven to not produce a radiation beam. As used herein, pixel refers to a single element of image on the substrate, as distinguished from the usage of the word pixel in connection with a portion of an image displayed on an assembled display device. For example, if the present invention is used to create a filter for a color display, the pixels created by the present invention will be combined with adjacent pixels, to form a single pixel (also referred to as a feature) of an image displayed on the display device.

Figure 2 shows a portion of a color filter receiver element 18 that has been conventionally patterned with a plurality of red stripe features 30A and 30B in a laser-induced thermal transfer process. Figure 2 depicts the correspondence between imaging channels 40 and the transferred pattern as broken lines 41. Features, such as stripes 30A and 30B generally have sizes that are greater than a width of a pixel imaged by an imaging channel 40. The radiation beams generated by imaging head 26 are scanned over receiver element 18 while being image-wise modulated according to image data specifying the pattern of features to be written. Groups 48 of channels 40 are driven to produce radiation beams wherever it is desired to form a feature. Channels 40 not corresponding to the features are controlled so as not to image corresponding areas.

Receiver element 18, imaging head 26, or a combination of both, are moved relative to one another while imaging channels 40 are controlled in response to image data to create image swaths. In some cases, imaging head 26 is stationary and receiver element 18 is moved. In other cases, receiver element 18 is stationary and imaging head 26 is moved. In still other cases, both the imaging head 26 and the receiver element 18 are moved.

Imaging channels 40 can be activated to form an image swath during a scan of imaging head 26. Receiver element 18 can be too large to be imaged within a single image swath. Multiple scans of imaging head 26 are typically required to complete an image on receiver element 18.

Movement of imaging head 26 along sub-scan axis 44 may occur after the imaging of each swath is completed along main-scan axis 42. Alternatively, with a drum-type imager, it may be possible to relatively move imaging head 26 along both the main-scan axis 42 and sub-scan axis 44, thus writing the image with swaths extending helically on the drum. In Figure 2, relative motion between imaging head 26 and receiver element 18 is provided along a path aligned with main-scan axis 42. In this case, receiver element 18 is movable in a forward direction 42A and in a reverse direction 42B with respect to imaging head 26. Forward direction 42A is opposite to reverse direction 42B. Receiver element 18 can reciprocate between forward direction 42A and reverse direction 42B. In Figure 2, relative motion between imaging head 26 and receiver element 18 is provided along a path aligned with sub-scan axis 44. In this case, imaging head 26A can move in an away direction 44A and in a home direction 44B. Away direction 44A is opposite to home direction 44B.

Any suitable mechanism may be applied to move imaging head 26 relative to receiver element 18. Flat bed imagers are typically used for imaging receiver elements 18 that are relatively rigid, as is common in fabricating display panels. A flat bed imager has a support that secures a receiver element 18 in a flat orientation. U.S. Patent 6,957,773 to Gelbart describes a high-speed flatbed imager suitable for display panel imaging. Alternatively, flexible receiver elements 18 can be secured to either an external or internal surface of a "drum-type" support to affect the imaging of the image swaths.

In Figure 2, stripe features 30A are imaged during a first scan in which imaging head 26 (in first position 38A) directs radiation beams towards receiver element 18 as receiver element 18 is moved in reverse direction 42B. On completion of the first scan, imaging head 26 (in first position 38A) is moved along sub-scan axis 44 to a second position 38B (shown in broken lines). Stripe features 30B are imaged during a second scan in which imaging head 26 (in new position 38B) directs radiation beams towards receiver element 18 as receiver element is moved in forward direction 42A. Stripe features 30A and 30B are imaged by bidirectional scanning techniques. Bidirectional scanning techniques can enhance imaging productivity since scans are made on both in a forward scanning direction and a reverse scanning direction.

Banding typically refers to an image artifact that repeats in a direction that intersects a direction in which the image swaths extend. Some banding artifacts are typically characterized by visual differences that repeat from image swath-to-image swath. For example, if adjacent image swaths are separated from one another by a gap, the gaps can repeat to produce a banding artifact. If adjacent image swaths overlap each other, the overlapped regions can repeat to produce a banding artifact. If density variations occur across each of the image swaths in a repeatable manner, the repeating density variations can produce a banding artifact. Banding artifacts can arise from image variations in areas proximate to image swath-to-image swath boundaries. Banding artifacts can arise from variations within an image swath that repeat from image swath-to-image swath. Many banding artifacts repeat on intervals related to the image swath width.

The present inventors have surprisingly noted that other image artifacts can arise when bidirectional imaging techniques are employed. Visual differences have been noted when a first image swath formed by scanning in a first direction is compared against a second image swath formed by scanning in a second direction that is opposite to the first direction. When many image swaths are formed using bidirectional scanning techniques in which image swaths imaged in the first direction alternate with image swaths imaged in the second direction, the visible differences between the adjacent swaths repeat to produce a "banding-like" artifact. In this case, the differences repeat every two swath widths when two image swaths formed by scanning in the first direction are separated from one another by a third image swath formed by scanning in the second direction. Visible differences can include differences in density (e.g. optical density or color density).

Referring back to Figure 2, visible differences can arise between stripe features 30A and 30B even though they are substantially identical in shape and size. Visible differences can occur even when a given stripe 30B is imaged during the second scan by the same group 48 of imaging channels used to image a given stripe 30A during the first scan. In this case, the bidirectional nature of the scans imparts visible differences between their associated imaged features.

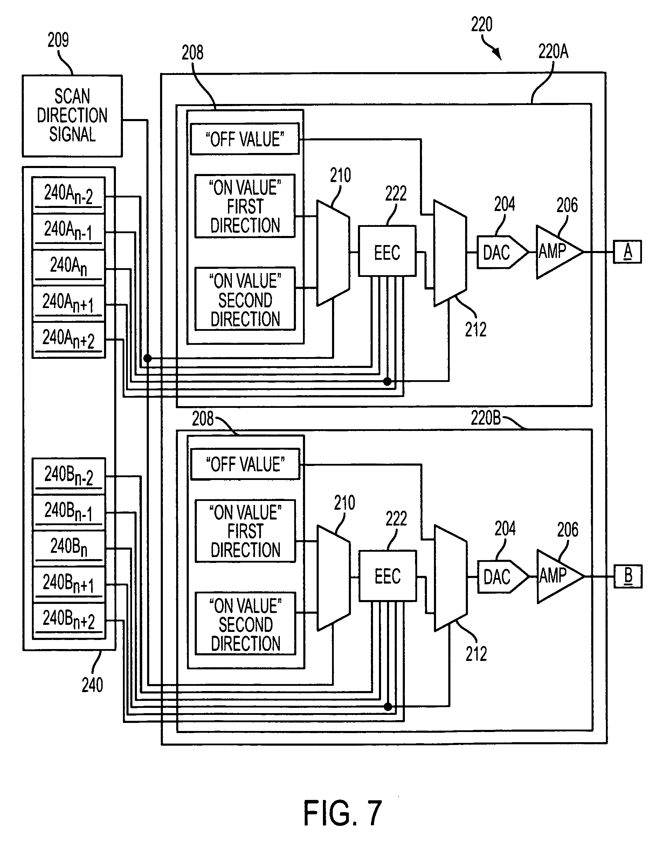

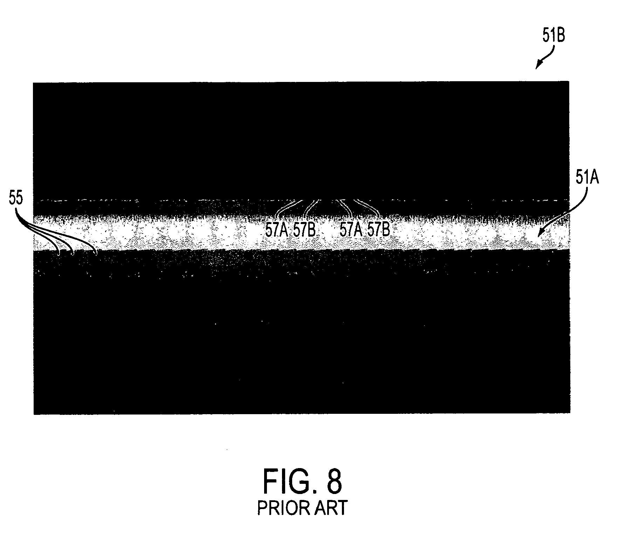

Figure 8 is a photograph comparing a series of image swaths imaged using conventional bidirectional and unidirectional techniques. Image 51A is imaged unidirectionally with a plurality of image swaths 55, each of which was scanned along a common direction. Image 51B is imaged bidirectionally with a plurality of image swaths 57A and 57 B. Image swaths 57A were scanned along a direction that is opposite to the direction in which image swaths 57B were scanned. Both images 51A and 51B were formed by laser-induced thermal transfer. Although some minor swath-to-swath banding was present (not clearly visible in this photograph), image 51A shows that each of image swaths 55 have similar visual characteristics. In comparison, image 51B clearly shows visual differences between the bidirectionally imaged swaths 57A and 57B. A banding artifact that repeats every two swaths is visible. Although this artifact is clearly visible with the unaided eye, the Figure 7 photograph has been enhanced for reproduction herein.

Although they do not want to be by any particular theory, the present inventors consider that one or more various causes can contribute to visual differences between the various image portions formed by bidirectional scans. Without limitation, one possible cause may include interaction effects between the radiation beams and the media itself. For example, in various laser induced thermal transfer processes, radiation beams are scanned across the media assemblage to cause an image forming material to separate from a donor element and be transferred to a receiver element. Various characteristics that are dependant on a particular direction of the scan may be developed within the transferred image forming material. For example, the shape of a transferred pixel of the image forming material may be dependant on the direction of the scan. The distribution of the transferred imaged forming material may also change in each direction. Optical properties such as reflectivity may vary as a function of direction.

Exposure, E is defined in optics as the integral of intensity over time. Many imageable media respond to exposure. Exposure is related to an intensity of a radiation beam and exposure time of the radiation beam. Exposure can be related to the scanning speed of the radiation beam. Some imageable media follow the "law of reciprocity". For example, a media that follows the law of reciprocity can be exposed by radiation intensity I for a duration t, or with radiation intensity 10I for a duration 0.1t with similar results. In either case, the exposure is the same (i.e. 10I x 0. It = I x t). Some media comprising photo-resists or electron beam resists are examples of media that behave substantially in accordance with the reciprocity law. There are other imageable media that do not obey the reciprocity law. Media that do not obey the reciprocity law include some thermal imaging materials. In some media, an image is formed when an exposure created by a radiation beam reaches, or exceeds an exposure threshold level associated with the media. In some media, the exposure threshold depends on the intensity. In some media, a minimum intensity threshold must be equaled or exceeded in order to form an image. In some cases, a media may behave substantially in accordance with the reciprocity law over a limited intensity range.

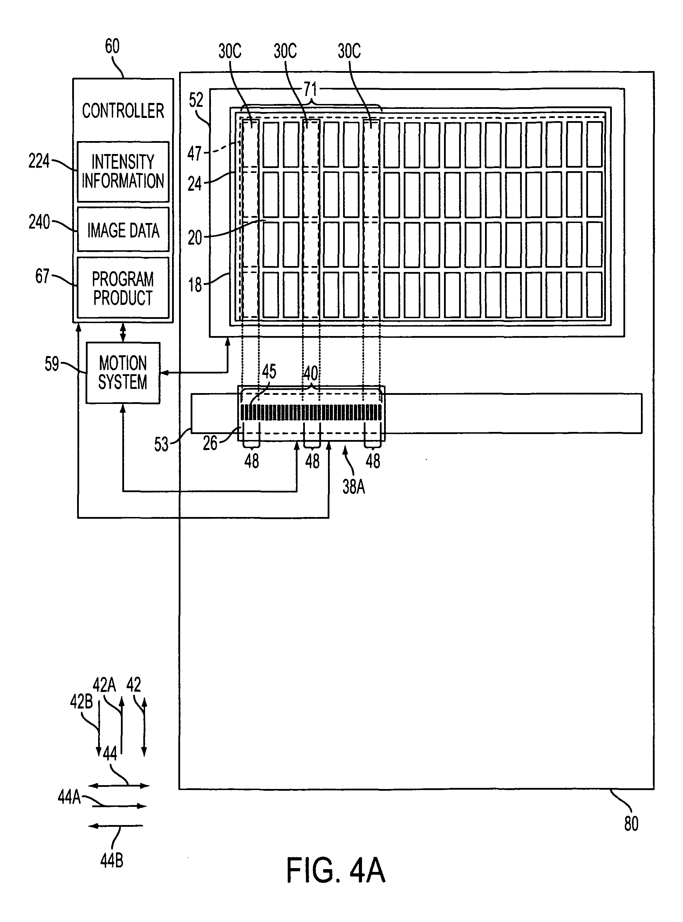

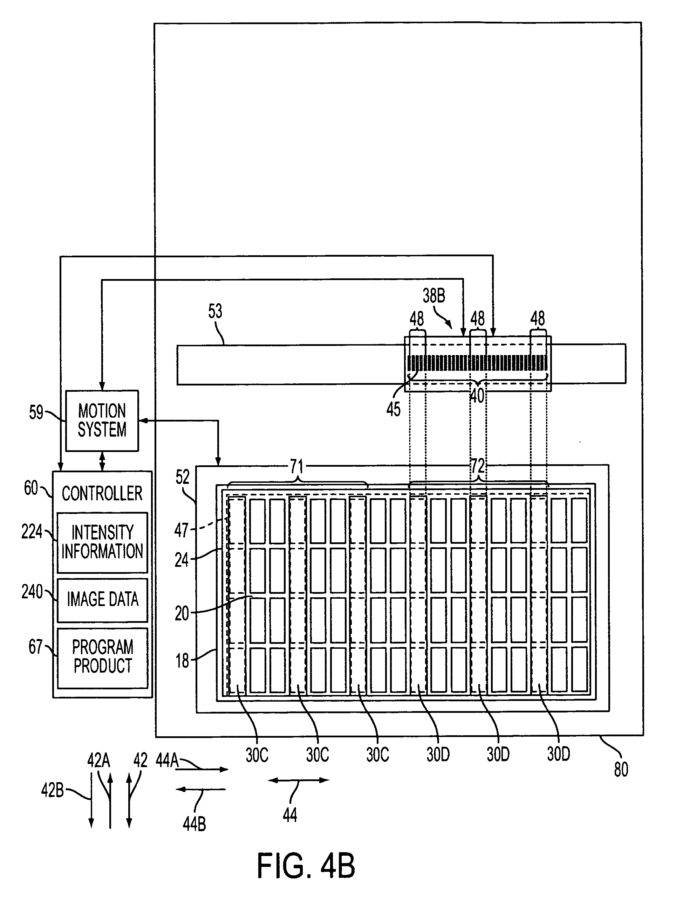

Figures 4A and 4B schematically show an apparatus 80 used in an example embodiment of the invention. Apparatus 80 is operable for forming images on receiver element 18. In this example embodiment of the invention, images are formed on receiver element 18 by operating imaging head 26 to direct radiation beams while scanning over receiver element 18. The operation of apparatus 80 during a first scan is shown in Figure 4A and the operation of apparatus 80 during a second scan is shown in Figure 4B.

Apparatus 80 includes carrier 52 which is operable for conveying receiver element 18 along a path aligned with main-scan axis 42. Carrier 52 can move in a reciprocating fashion. In this example embodiment of the invention, carrier is movable in a forward direction 42A and a reverse direction 42B. Imaging head 26 is arranged on a support 53 that straddles carrier 52. Imaging head 26 is controlled to move along paths aligned with sub-scan axis 44. In this example embodiment of the invention imaging head 26 can be controlled to move along support 53. Imaging head 26 is movable in away direction 44A and in home direction 44B. Apparatus 80 forms images by bi-directionally scanning receiver element 18.

In this example embodiment of the invention, a laser induced thermal transfer process is employed. Imaging head 26 is controlled to scan the media with a plurality of radiation beams to cause an image forming material (not shown) to be transferred from donor element 24 to receiver element 18. Imaging electronics (not shown) control activation timing of the imaging channels 40 to regulate the emission of the radiation beams. Motion system 59 (which can include one or more motion systems) includes any suitable prime movers, transmission members, and / or guide members to cause the motion of carrier 52. In this example embodiment of the invention, motion system 59 controls the motion of imaging head 26 and controls the motion of carrier 52. Those skilled in the related art will realize that separate motion systems can also be used to operate different systems within apparatus 80.

Controller 60, which can include one or more controllers, is used to control one or more systems of apparatus 50 including, but not limited to, various motion systems 59 used by carrier 52 and imaging head 26. Controller 60 can also control media handling mechanisms that can initiate the loading and /or unloading of receiver element 18 and donor element 24. Controller 60 can also provide image data 240 to imaging head 26 and control imaging head 26 to emit radiation beams in accordance with this data. Various systems can be controlled using various control signals and/or by implementing various methods. Controller 60 can be configured to execute suitable software and can include one or more data processors, together with suitable hardware, including by way of non-limiting example: accessible memory, logic circuitry, drivers, amplifiers, A/D and D/A converters, input / output ports and the like. Controller 60 can comprise, without limitation, a microprocessor, a computer-on-a-chip, the CPU of a computer or any other suitable microcontroller.

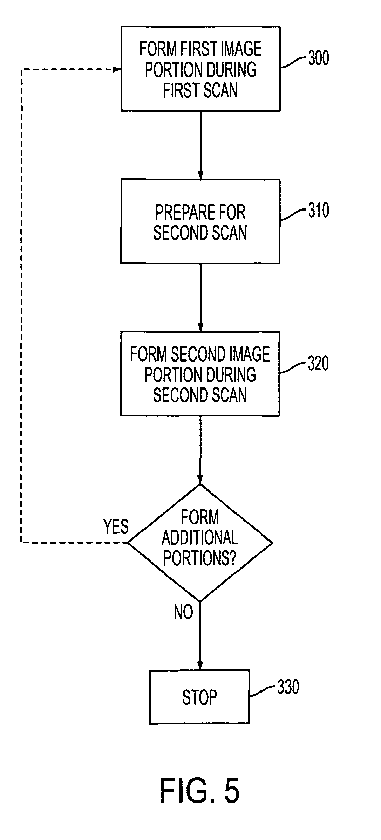

The present invention provides systems and methods in which an intensity of the radiation beams produced by imaging head 26 are adjusted in ways that reduce image artifacts when bi-directional scanning techniques are employed. Figure 5 shows a flow chart for imaging a pattern of features such as stripe features 30C and 30D shown in Figures 4A and 4B as per an example embodiment of the invention. Stripe features 30C and 30D are similar to stripe features 30A and 30B shown in Figure 2 and are collectively referred to as stripe features 30. The pattern of features is formed by a plurality of scans. The following description of the Figure 5 flow chart refers to apparatus 80 as schematically shown in Figures 4A and 4B, although it is understood that other apparatus are suitable for use with the illustrated process. The process begins at step 300 where imaging head 26 forms a first portion 71 of the image on receiver element 18. In this example embodiment of the invention, the first image portion 71 includes stripe features 30C. Controller 60 controls imaging head 26 to direct radiation beams along a first scan path to form first image portion 71 on receiver element 18.

As schematically shown in Figure 4A, first image portion 71 is formed during a first scan in which imaging head 26 is operated to scan groups of radiation beams in a first scan direction. In this example embodiment, each stripe feature 30C is imaged by a plurality of radiation beams during a first scan. During the first scan, controller 60 controls motion system 59 to move carrier 52 along a first path. In this example, carrier 52 is moved in reverse direction 42B. In this example embodiment of the invention, carrier 52 can accelerate from a starting speed (which can include a zero velocity) to a speed suitable for scanning. In this example embodiment of the invention, the speed is held constant as imaging head 26 directs radiation beams to form first image portion 71.

Stripe features 30C in first image portion 71 are formed in accordance with image data 240 corresponding to image portion 71. Image data 240 can include raster data. Controller 60 controls the activation of radiation beams emitted from imaging head 26 in accordance with image data 240. In this example embodiment, imaging head 26 has a plurality of imaging channels 40 and each stripe feature 30C is imaged by a group 48 of imaging channels 40. In this example embodiment, each group 48 is made up of approximately five contiguous imaging channels 40. An imaging channel 40 can be turned "on" emit a radiation beam. Each time the imaging channel is turned on, it emits a radiation beam. In this case, a radiation beam can be used to transfer material from donor element 24 to receiver element 18 along a scan line corresponding to the channel. Channels (i.e. such as imaging channel 45) in groups 48 are turned "on". An imaging channel 40 may also be turned "off" so that a radiation beam is not emitted. The intensity of each beam is controllable from an inactive intensity level in which the imaging channel is turned "off" to an active intensity level in which the channel is turned "on". The inactive intensity level can include an intensity level equal to zero or some small intensity level representative of various leakage effects. Some example embodiments of this invention (e.g. those employing independently modulated laser sources) have inactive intensity levels equal to zero.

The active intensity level of the imaging beam is also adjustable and some material may be transferred between donor element 24 and receiver element 18 across a range of intensity levels. Adjustment of intensity can include, for example, modulating the intensity of the beam. Adjustment of intensity can include, for example, attenuating the intensity of the beam. Adjustment of intensity can include, for example, adjusting a power of the beam. Controller 60 controls imaging channels 40 selected to emit radiation beams with intensities suitable for forming imaged pixels base on several factors. For example, in accordance with image data 240, imaging channel 45 emits a radiation beam (not shown) suitable for forming an image pixel that forms a part of one of the stripe features 30A. The intensity of the radiation beam will be based in part on the properties of the media that is to be imaged. In some example embodiments of the invention, the intensity of the radiation beam emitted by imaging channel 45 is controlled to equal or exceed an exposure threshold associated with the media. In some example embodiments of the invention, the intensity of the radiation beam emitted by imaging channel 45 is controlled to equal, or exceed an intensity threshold associated with the media. In some example embodiments of the invention, the intensity of the radiation beam emitted by imaging channel 45 is varied in relation to a desired scanning speed.

Controller 60 controls imaging channels such as imaging channel 45 to form image pixels that will result in the formation of desired visible characteristics in image portion 71. In this example embodiment of the invention, imaging channel 45 is controlled to vary the intensity of its emitted radiation beam as a function of the scanning direction. Controller 60 can determine the scan direction that is required during the formation of image portion 71 in various ways. In one example embodiment, imaging head 26 receives a digital real time signal (not shown) named "imaging" and a clock signal which controls the activation timing of imaging channels 40. Pixel data is received by imaging head 26 and is buffered in an internal memory. The imaging signal and the clock signal determine the specific time for imaging head 26 to form a given pixel onto the media. The imaging signal activates at the start of the formation of an image swath and remains active for the entire time that the image swath is being formed on the media. The imaging signal will then become inactive until the imaging of the next image swath commences. In this example embodiment, each activation of the imaging signal occurs during one of the alternating scan directions. The imaging signal is thereby used to determine the scan direction during the formation of the various image portions. Those skilled in the related art will realize that other methods of determining the scan direction can be readily used by the present invention.

On completion of the first scan, apparatus 80 is prepared to image a second image portion 72 during a second scan as shown in step 310. In this example embodiment of the invention, second image portion 72 includes stripe features 30D. Controller 60 can prepare apparatus 80 for the second scan in various ways. In this example embodiment of the invention, imaging head 26 was at a first sub-scan position (i.e. position 38A) while scanning along the scan path related to the first scan. In this example embodiment of the invention, controller 60 causes motion system 59 to move imaging head 26 along sub-scan axis 44 to a second position 38B after the first scan. Imaging head 26 can be moved from the first position 38A to the second position 38B in various ways. For example, imaging head 26 can move between the two positions as carrier 52 decelerates from a speed employed during the first scan, and / or as carrier 52 accelerates to another speed used in a subsequent scan. Carrier 52 can move through a point of zero velocity as imaging head moves between the two positions. Carrier 52 can pause as imaging head 26 moves between moving between the two positions. In some example embodiments of the invention, imaging head 26 moves from first position 38A to second position 38B by a distance that is less than the width of an image swath. In some example embodiments, second position 38B is the same as first position 38A (i.e. in a sub-scan direction).

In step 320 imaging head 26 forms second image portion 72 on receiver element 18. As schematically shown in Figure 4B, controller 60 controls imaging head 26 to direct radiation beams in a second scan direction to form second image portion 72 on receiver element 18. The second scan direction is opposite to the first scan direction. During the second scan, controller 60 controls motion system 59 to move carrier 52 along a second path. In this example embodiment of the invention, motion system 59 to moves carrier 52 with a constant speed as imaging head 26 directs radiation beams to form second image portion 72. Image portions 72 and 71 are imaged bidirectionally.

Controller 60 controls imaging channels 40 selected to emit radiation beams with intensities suitable for forming image portion 72. In this example embodiment of the invention, the intensity of the radiation beams emitted by a given channel while scanning in the second direction is controlled to be different than the intensity of the radiation beams emitted by the same channel while scanning in the first direction. For example, in accordance with image data 240, imaging channel 45 has been selected to form image pixels during both the first scan and the second scan. Controller 60 operated imaging channel 45 to emit a radiation beam with a first intensity while scanning in the first direction during the first scan. During the second scan, controller 60 operated imaging channel 45 to emit a radiation beam with a second intensity while scanning in the second direction. The second intensity is different form the first intensity and is selected to enhance the imaging of second image portion 72. The second intensity forms part of set of imaging parameters selected to overcome differences in visual characteristics of second image portion 72 that would occur if it was imaged with the same image parameters employed in the imaging of first image portion 71. In some example embodiments of the invention, the second intensity is selected to produce a different exposure during the imaging of the second image portion 72 than the exposure produced during the imaging of the first image portion 71. This example embodiment of the invention can be used to create imaged features that have substantially the same visual characteristics while benefiting from the productivity gains associated with bi-directional scans.

The optimal intensity for the second scan can be determined by a trial and error test. For example, various test pattern images can be formed using scans at different intensities and examined to determine the best intensity to minimize differences in visual characteristics.

An example of a measure that can be used to compare an visual characteristic of two imaged portions is the value ΔE that represents color differences in the CIE 1976 L*, a*, b* ("CIELAB") system as defined by the Commission International de l'Eclairage (CIE). In some embodiments the differences in intensities are sufficient to achieve ΔE between the image portions (e.g. stripe features 30C and 30D) of 3 or less, 2 or less, and preferably 1 or less. In demanding applications ΔE may be 0.7 or less (e.g. about ½ or less).

Color density is another visual characteristic that can be compared between the imaged portions 71 and 72. Various reflectivity or transmissivity measures can be compared between the imaged portions 71 and 72.

After the formation of image second portion 72, the imaging process can stop as shown in step 330. Alternatively, additional portions of the image can be formed as per various embodiments of the invention by repeating steps 300, 310 and 320. Alternatively, additional portions of the image can be produced by other techniques.

In some example embodiments of the invention, various portions of the image can be formed in an interleaved fashion. For example, a first image portion can include a plurality of image sub-portions that are separated from one another in one or more directions. Each of the image sub-portions are formed by scanning in a first direction during a first scan. A second image portion can be formed between the separated sub-portions by scanning in a second direction opposite to the first direction during a second scan. A first image portion can be overlapped by a second image portion. Features formed in a second image portion can be contiguous or non-contiguous with features formed in a first image portion.

The intensity of radiation beams emitted by each imaging channel 40 can be varied in a number of different ways. In some example embodiments of the invention, imaging head 26 includes a spatial light modulator (light valve) that is illuminated by a constant laser source. The laser is driven by a constant current source adjusted to maintain a desired overall power. The light valve is used to attenuate the intensity of the radiation beams emitted from each channel of the light valve to a desired intensity for that channel. For each scan direction, a light valve driver switches between two levels for each channel, one for "off" and one for "on". The level for "on" while scanning in a first direction differs from the level for "on" while scanning in a second direction opposite to the first direction. In this example embodiment, the light valve works as an analog device that can supply a variable attenuation per channel.

In other example embodiments, the intensity of radiation beams emitted by each imaging channel 40 can be varied by an imaging head 26 which uses a constant laser source with a pulse width modulated light valve. The laser is driven using a constant current source adjusted to maintain a desired overall power. The light valve is used to attenuate the intensity of the radiation beams emitted from each channel of the light valve to a desired intensity for that channel. The level for "on" while scanning in a first direction differs from the level for "on" while scanning in a second direction opposite to the first direction. The light valve is used in a digital fashion such that a given channel is either "on" or "off" but the duty cycle is adjusted to control a desired intensity of the beam emitted from that channel.

In other example embodiments, the intensity of radiation beams emitted by each imaging channel 40 can be varied by an imaging head 26 which uses a pulse width modulated laser source with a variable attenuation light valve. The laser is driven using a pulse width modulator where the duty cycle is adjusted to maintain the desired overall power. The light valve is used to attenuate the intensity of the radiation beams emitted from each channel of the light valve to a desired intensity for that channel. The level for "on" while scanning in a first direction differs from the level for "on" while scanning in a second direction opposite to the first direction. In this embodiment, the light valve works as an analog device that can supply a variable attenuation per channel. Those skilled in the art will realize that other methods and imaging head configurations can be used to vary the intensity of a radiation beam emitted by an imaging channel. In some embodiments, the imaging head does not include a light valve. In some embodiments the imaging channels are individual laser sources.

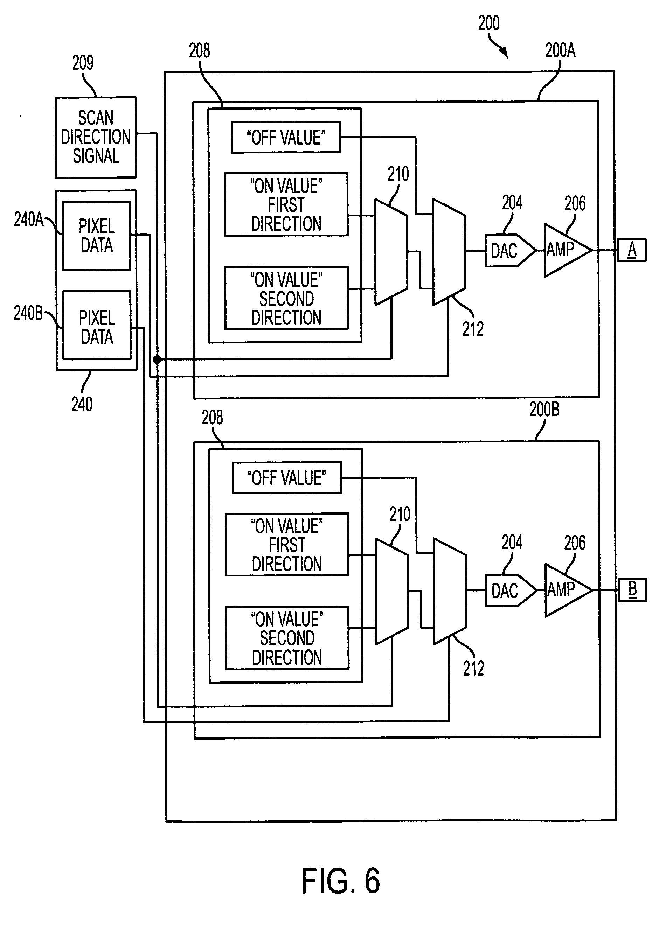

Figure 6 shows a schematic block diagram illustrating a logic used by a light valve driver system 200 as per an example embodiment of the invention. Light valve driver system 200 is used to operate a light valve of an imaging head. Light valve driver 200 system controls the activation of a number of channels of the light valve. By way of example only, two drivers 200A and 200B are shown and each driver controls a corresponding channel "A" AND "B" of the light valve. Each driver includes a digital-to-analog converter 204 (DAC 204) to produce an analog signal proportional to the desired output voltage. A high voltage amplifier 206 (AMP 206) is used to boost the signal to cover the desired output range. For each channel, light valve driver system 200 uses a lookup table 208 that stores separate "on values" for each of the opposing scan directions and an "off value". Each of the on values corresponds to a drive signal appropriate to cause a corresponding channel to emit a radiation beam with an intensity required by that scan direction. On every update clock, selection multiplexer 210 reads a scan direction signal 209 associated with image data 240 and assigns an appropriate "on" value corresponding to that direction. Selection multiplexer 212 reads image data 240 to decide whether each channel should be set to "off" or "on". In this example, pixel data 240A corresponds to channel "A" and pixel data 240B corresponds to channel "B". Depending on the pixel data for that channel (i.e. "on -data " or "off-data " that dictate whether an image pixel is to be formed or not) selection multiplexer 212 selects the "off value" or an "on value" corresponding to scan direction signal 209.

In some example embodiments of the invention, the intensity of a radiation beam emitted by a given imaging channel 40 is adjusted in accordance with the position of an image pixel formed by that beam in relation to other formed image pixels. Individual pixels are formed in relation to one another to produce various portions of an imaged feature. It may be desired to form various image pixels differently from one another to enhance imaging. For example, one or more pixels corresponding to edge portions of a feature may be imaged with radiation beams that have intensities that are different than the intensities of radiation beams that are used to image other portions of the feature. "Edge pixels" corresponding to edge portions need not be limited to the perimeter pixels of an imaged feature and can include one or more additional pixels that do not directly form the perimeter of the feature. The additional pixels can include select inboard pixels of the imaged feature. In one example embodiment of the invention, corresponding edge portions of a feature may be imaged with radiation beams that have higher intensities than the intensities of radiation beams that are used to image other portions of the feature. The edge portions can be parallel to one of the first or second scan directions, or can extend in a direction that intersects one of the first or second scan directions. Increasing the intensity of various radiation beams used to form edge portions of an imaged feature can be used to enhance a visual characteristic of the features and reduce artifacts such as edge discontinuities. Edge discontinuities can occur for a number of reasons including for example, differential thermal effects that can arise near the transition between imaged and non imaged areas. In the case of thermal transfer, mechanical effects, such as insufficient peel strength associated with the image-forming material transferred to the edges of the features or insufficient control of peel speed, angle or direction, may lead to edge discontinuities when the imaged donor element is peeled away. Selectively increased intensities can be used to help alleviate image artifacts such as edge discontinuities. In some example embodiments, an imaging channel can form a first pixel and second pixel with respective radiation beams of differing intensities. Each of the first and second pixels is formed while scanning in one of two opposing scan directions. The first and second pixels can be used to form an interior portion of one or more features formed on a media. The same imaging channel, or a different imaging channel can be operated to emit a radiation beam having an intensity to form a third pixel, wherein the third pixel is part of an edge portion of one of the one or more features. The intensity of the radiation beam used to form the third pixel can be greater than the intensities of the radiation beams used to form the first and second pixels. The third pixel can be formed during the same scan that either of the first or second pixel are formed in.

Figure 7 shows a schematic block diagram illustrating another logic used by a light valve driver system 220 as per an example embodiment of the invention. In this example embodiment of the invention, the intensity of a radiation beam emitted by a given imaging channel 40 is adjusted in accordance with a scan direction and with the position of an image pixel formed by that beam in relation to other formed image pixels. Like light valve driver system 200, light valve driver system 220 includes two drivers 220A and 220B which include various DACs 204, AMPs 206, and selection multiplexers 210. Light valve driver system 220 controls the activation of a number of channels of a light valve (again, by way of example only, two channels "A" and "B" are shown). In this example embodiment, each of drivers 220A and 220B uses a lookup table 208 that stores separate "on values" for each of the scan directions and an "off value". On every update clock, selection multiplexer 210 reads a scan direction signal 209 associated with the read image data 240 and assigns an appropriate "on value" corresponding to that direction. Selection multiplexer 212 reads image data 240 to decide whether each channel should be set with the "off value" or an "on value" corresponding to the scan direction signal.

Each of drivers 220A and 220B also includes edge enhancement circuitry 222 (EEC 222) used to determine if image data 240 corresponds to particular portion of a feature to be imaged. In this example, the portion is an edge portion of the feature. Features such as color filter features are typically formed by a plurality of contiguous image pixels. In this example embodiment of the invention, edge enhancement circuitry 222 reviews the pixel data and determines whether a current pixel "n" corresponds to an interior portion of the feature, an edge portion of the feature, or an un-imaged area. For example, when considering driver 220A, pixel data 240Aₙ is compared against two neighboring pixels worth of data on either side of it (i.e. 240Aₙ₋₂, 240Aₙ₋₁, and 240Aₙ₊₁, 240Aₙ₊₂). Two pixels worth of data is selected by way of example only. In this example, embodiment, the arrangement of pixel data 240Aₙ₋₂, 240Aₙ₋₁, 240Aₙ, 240Aₙ₊₁, and 240Aₙ₊₂ correspond to a single dimension (i.e. in a scan direction or transverse to the scan direction). The stream of the pixel data can correspond to an arrangement of data that is sequentially fed to a given channel to cause the pixels to be sequentially imaged in the scan direction. Alternatively, the pixel data can correspond to an arrangement of pixel data that is provided across a group of the channels at a given time. In this case, pixel data corresponding to one channel is compared with pixel data corresponding to other channels. In some example embodiments of the invention, pixel data is analyzed in two dimensions. In this example embodiment of the invention, pixel data 240Aₙ is compared against it neighboring pixels and if it is determined that that pixel data 240Aₙ corresponds to an edge portion of the image feature, then the "on-value" is further adjusted to cause a corresponding channel to emit a radiation beam with an increased or boosted intensity level over the beams used to form interior portions of the feature. Determination of whether pixel data 240Aₙ corresponds to an edge portion is easily made by determining which of the other pixel data represent imaged or un-imaged pixel regions. Driver 220B is operated in similar fashion by analyzing pixel data 240Bₙ₋₂, 240Bₙ₋₁, 240Bₙ, 240Bₙ₊₁, and 240Bₙ₊₂.

In some example embodiments of the invention, each "on-value" corresponding to a given scan direction is increased by the same amount if the pixel data corresponds to an edge of the feature. In some example embodiments of the invention, each of the "on values" is adjusted by different amounts. In some example embodiments of the invention, the "on values" are adjusted proportionally. In some example embodiments of the invention, the "on values" are adjusted to the same value.

In some example embodiments of the invention, an imaging channel 40 is turned "on" to emit a radiation beam having an active intensity level greater than an inactive intensity level created when the channel is turned "off". This active intensity level can be incapable of forming an image pixel on a media. In some example embodiments of the invention, the intensity level of the beam is below an intensity threshold. In some example embodiments, the intensity of the beam is controlled to create an exposure less than an exposure threshold of the media. Controlling an imaging channel to emit a radiation beam with an intensity level incapable of forming an image pixel is referred to as below-threshold imaging. Below-threshold imaging can be used to enhance a visual characteristic of image features and help reduce some image artifacts. For example, below-threshold imaging can be used to change a thermal characteristic in an area at, or near an image pixel to improve a particular characteristic of that image pixel. In the case of laser-induced thermal transfer, below-threshold imaging techniques can be used to promote the adhesion of an image forming material that is transferred from a donor element to receiver element during the formation of an image pixel. In some example embodiments, below-threshold imaging is used to vary the amount of image forming material that is transferred to a given pixel or a neighboring image pixel to achieve a desired characteristic such as density.

In some example embodiments of the invention, logic circuitry similar to that shown in Figure 7 is used to form various radiation beams with below-threshold intensities. These radiation beams can be used to scan regions of the media that are represented by "off data " of the pixel data used to control the turning on and off of corresponding imaging channels 40. In some example embodiments, these regions are proximately positioned to imaged pixels. In some example embodiments, "off-values" corresponding to these regions can be adjusted to cause corresponding channels to emit a radiation beam with a below threshold intensity. In some example embodiments, imaged pixels are pre-exposed or post exposed with radiation beams with below threshold intensities. This below threshold exposure can preheat or post heat the media. In some example embodiments, the below-threshold intensities can vary as a function of scan direction.

Imaging head 26 can comprise a multi-channel imaging head having individually-addressable imaging channels, each channel capable of producing a radiation beam operable form forming an image pixel. Imaging head 26 can include various arrangements of imaging channels 40 including one-dimensional or two-dimensional arrays of imaging channels 40. Any suitable mechanism may be used to generate radiation beams. The radiation beams may be arranged in any suitable way.

Some embodiments of the invention employ infrared lasers. Infrared diode laser arrays employing 150 µm emitters with total power output of around 50W at a wavelength of 830 nm have been used by the present inventors in laser induced thermal transfer processes. Alternative lasers including visible light lasers may also be used in practicing the invention. The choice of laser source employed may be motivated by the properties of the media to be imaged.

Various example embodiments of the invention have been described in terms of a laser induced thermal transfer processes in which an image forming material is transferred to a receiver element. Other example embodiments of the invention can be employed with other imaging processes and media. Images can be formed on media by different processes without departing from the scope of the present invention. For example, media can include an image modifiable surface, wherein a property or characteristic of the modifiable surface is changed when irradiated by a radiation beam to form an image. A radiation beam can be used to ablate a surface of media to form an image. Those skilled in the art will realize that different imaging processes can be readily employed.

A program product 67 can be used by controller 60 to perform various functions required by apparatus 80. One such function can include setting control parameters as a function of scan direction for imaging head 26 to establish image portions with substantially similar visual characteristics as described herein. Without limitation, program product 67 may comprise any medium which carries a set of computer-readable signals comprising instructions which, when executed by a computer processor, cause the computer processor to execute a method as described herein. The program product 67 may be in any of a wide variety of forms. Program product 67 can comprise, for example, physical media such as magnetic storage media including, floppy diskettes, hard disk drives, optical data storage media including CD ROMs, DVDs, electronic data storage media including ROMs, flash RAM, or the like. The instructions can optionally be compressed and / or encrypted on the medium.

In one example embodiment of the invention, program product 67 can be used to configure controller 60 to cause an imaging channel 40 to emit a radiation beam having a first intensity while scanning over receiver element 18 in a first direction during a first scan, and cause the imaging channel 40 to emit a radiation beam having a second intensity different from the first intensity while scanning in a second direction opposite to the first direction during a second scan. Various image portions can be formed by the radiation beams during each scan. In the alternative, or additionally, controller 60 may permit manual assignment or adjustment of the radiation beam intensities under the guidance of an operator communicating with controller 60 through an appropriate user interface. Determination of intensity differences can be made on the basis of suitable algorithms and/or data inputted to controller 60, or programmed within program product 67. The control parameters can be determined in advance of imaging or may be determined "on the fly" as imaging progresses.

In some example embodiments, controller 60 maintains intensity information 224 for each imaging channel 40 that specifies different intensity values to set for radiation beams emitted by each channel as a function of scan direction. If it is determined that an imaging channel 40 is required to emit a radiation beam while scanning in a determined scan direction, controller 60 can automatically set the channel to the value specified by intensity information 224.

In some example embodiments, controller 60 maintains intensity information 224 for each imaging channel 40 that specifies different intensity values to set for the radiation beams while forming image pixels while scanning in different scan directions. Controller 60 can maintain intensity information 224 for each imaging channel 40 that specifies different intensity values to set for the radiation beams to expose the media to different exposures while scanning in different scan directions. Controller 60 can maintain intensity information 224 for each imaging channel that specifies sets of various intensity values to set for the radiation beams as a function of the direction in which the beams are scanned. Each of the sets can include one or more intensity values that are different from the intensity values of other sets.

In some example embodiments, controller 60 maintains intensity information 224 for each imaging channel 40 that specifies a boost in intensity for radiation beam selected to form a particular portion of an imaged feature while scanning in a given scan direction. The portion of the feature can include an edge portion of the feature. The boosted intensity values are greater than the intensity values of radiation beams used to form other portions of the feature while scanning in the corresponding scan direction. Different levels of intensity boost can be set for each of the scan directions.

In some example embodiments, controller 60 maintains intensity information 224 for each imaging channel 40 that specifies a below-threshold intensity to set for radiation beam emitted by an imaging channel 40 while scanning in a given scan direction. Different levels of below-threshold intensity can be set for each of the scan directions.

Patterns of features have been described in terms of patterns of color features in a display. In some example embodiments of the invention, the features can be part of an LCD display. In other example embodiments of the inventions, the features can be part of an organic light-emitting diode (OLED) display. OLED displays can include different configurations. For example, in a fashion similar to LCD display, different color features can be formed into a color filter used in conjunction with a white OLED source. Alternatively, different color illumination sources in the display can be formed with different OLED materials with various embodiments of the invention. In these embodiments, the OLED based illumination sources themselves control the emission of colored light without necessarily requiring a passive color filter. OLED materials can be transferred to suitable media. OLED materials can be transferred to a receiver element with laser-induced thermal transfer techniques.

Various example embodiments of the invention have been described in terms of imaging stripe features. The stripes can have edges extending parallel to a scan direction. The stripes can be continuous or interrupted. The invention however is not limited to imaging stripes but can be used to image features that include other shapes. The invention can be used to image island features also.

While the invention has been described using as examples applications in display and electronic device fabrication, the methods described herein are directly applicable to other applications including those used in biomedical imaging for lab-on-a-chip (LOC) fabrication. LOC devices may include various patterns of features. The invention can have application to other technologies, such as medical, printing and electronic fabrication technologies.

It is to be understood that the exemplary embodiments are merely illustrative of the present invention and that many variations of the above-described embodiments can be devised by one skilled in the art without departing from the scope of the invention.

## Claims

1. A thermal transfer imaging method comprising:
operating an imaging head to emit a plurality of independently-controllable radiation beams while scanning over a donor element to form an image on a receiver element;
operating an imaging channel of the imaging head to emit a radiation beam having a first intensity while scanning in a first direction over the donor element during a first scan; and
operating the imaging channel to emit a radiation beam having a second intensity while scanning in a second direction over the donor element during a second scan, wherein the second direction is opposite to the first direction and the second intensity is different from the first intensity.

2. A method according to Claim 1, comprising forming a first pixel with the radiation beam having the first intensity during the first scan, and forming a second pixel with the radiation beam having the second intensity during the second scan.

3. A method according to Claim 2, comprising forming the first pixel with a first exposure and forming the second pixel with a second exposure, wherein the second exposure is formed differently from the first exposure.

4. A method according to Claim 2, comprising forming the first pixel with a first exposure and forming the second pixel with a second exposure wherein the second exposure is greater than the first exposure.

5. A method according to Claim 1, wherein each of the first intensity and the second intensity are sufficient to create an exposure greater than, or equal to an exposure threshold of the donor element during each of the first scan and the second scan.

6. A method according to Claim I5wherein each of the first intensity and the second intensity are greater than leakage intensity occurring when the imaging channel is operated not to emit a radiation beam.

7. A method according to Claim 1, comprising establishing relative motion between the imaging head and the receiver element while forming the image.

8. A method according to Claim 1, comprising selecting the first intensity to be different from the second intensity.

9. A method according to Claim 1, wherein the imaging head comprises a light valve, the method comprising attenuating a channel of the light valve to make the second intensity different from the first intensity.

10. A method according to Claim 1, wherein the imaging head comprises a light valve, the method comprising pulse width modulating a channel of the light valve to make the second intensity different from the first intensity.

11. A method according to Claim 1, comprising varying power provided to the imaging channel to make the second intensity different from the first intensity.

12. A method according to Claim 2, wherein the first pixel forms part of an edge portion of a feature formed on the receiver element and the second pixel forms part of another edge portion of a feature formed on the receiver element.

13. A method according to Claim 2, wherein the first pixel forms an interior portion of a feature formed on the receiver element and the second pixel forms an edge portion of the feature.

14. A method according to Claim 2, wherein the first pixel forms part of an edge portion of a feature formed on the receiver element and wherein the second pixel forms part of an interior portion of an additional feature formed on the receiver element.

15. A method according to Claim 2, wherein each of the first pixel and the second pixel forms part of an edge portion of a feature formed on the receiver element.

## Patentansprüche

1. Thermotransfer-Bebilderungs verfahren, umfassend:
Betreiben eines Abbildungskopfes zum Abgeben einer Vielzahl unabhängig voneinander steuerbarer Strahlenbündel, während ein Geberelement abgetastet wird, um ein Bild auf einem Empfangselement zu erzeugen;
Betreiben eines Abbildungskanals des Abbildungskopfes zum Abgeben eines Strahlenbündels mit einer ersten Intensität, während bei einer ersten Abtastung das Geberelement in einer ersten Richtung abgetastet wird; und
Betreiben des Abbildungskanals zum Abgeben eines Strahlenbündels mit einer zweiten Intensität, während bei einer zweiten Abtastung das Geberelement in einer zweiten Richtung abgetastet wird, worin die zweite Richtung zur ersten Richtung entgegengesetzt verläuft und die zweite Intensität sich von der ersten Intensität unterscheidet.

2. Verfahren nach Anspruch 1, umfassend das Erzeugen eines ersten Pixels, wobei das Strahlenbündel bei der ersten Abtastung die erste Intensität aufweist, und Erzeugen eines zweiten Pixels, wobei das Strahlenbündel bei der zweiten Abtastung die zweite Intensität aufweist.

3. Verfahren nach Anspruch 2, umfassend das Erzeugen des ersten Pixels mit einer ersten Belichtung und Erzeugen des zweiten Pixels mit einer zweiten Belichtung, worin die zweite Belichtung sich von der ersten Belichtung unterscheidet.

4. Verfahren nach Anspruch 2, umfassend das Erzeugen des ersten Pixels mit einer ersten Belichtung und Erzeugen des zweiten Pixels mit einer zweiten Belichtung, worin die zweite Belichtung größer als die erste Belichtung ist.

5. Verfahren nach Anspruch 1, worin die erste und zweite Intensität jeweils ausreichen, um eine Belichtung zu erzeugen, die größer als oder gleich einem Belichtungsschwellenwert des Geberelements während jeweils der ersten und zweiten Abtastung ist.

6. Verfahren nach Anspruch 5, worin die erste und zweite Intensität jeweils größer als die Leckintensität sind, die auftritt, wenn der Abbildungskanal derart betrieben wird, dass er kein Strahlenbündel abgibt.

7. Verfahren nach Anspruch 1, umfassend das Erzeugen einer Relativbewegung zwischen dem Abbildungskopf und dem Empfangselement, während das Bild erstellt wird.

8. Verfahren nach Anspruch 1, umfassend das Auswählen der ersten Intensität derart, dass sie sich von der zweiten Intensität unterscheidet.

9. Verfahren nach Anspruch 1, worin der Abbildungskopf ein Lichtventil aufweist, wobei das Verfahren das Abschwächen des Lichts im Lichtventil eines Kanals umfasst, derart, dass sich die zweite Intensität von der ersten Intensität unterscheidet.

10. Verfahren nach Anspruch 1, worin der Abbildungskopf ein Lichtventil aufweist, wobei das Verfahren die Pulsweitenmodulation des Lichtventils eines Kanals umfasst, derart, dass sich die zweite Intensität von der ersten Intensität unterscheidet.

11. Verfahren nach Anspruch 1, umfassend das Verändern der für den Abbildungskanal bereitgestellten Leistung, derart, dass sich die zweite Intensität von der ersten Intensität unterscheidet.

12. Verfahren nach Anspruch 2, worin das erste Pixel Teil eines Randabschnitts eines Merkmals ist, das auf dem Empfangselement erzeugt wird, und worin das zweite Pixel Teil eines weiteren Randabschnitts eines Merkmals ist, das auf dem Empfangselement erzeugt wird.

13. Verfahren nach Anspruch 2, worin das erste Pixel einen Innenabschnitt eines Merkmals bildet, das auf dem Empfangselement erzeugt wird, und das zweite Pixel einen Randabschnitt des Merkmals bildet.

14. Verfahren nach Anspruch 2, worin das erste Pixel Teil eines Randabschnitts eines Merkmals ist, das auf dem Empfangselement erzeugt wird, und worin das zweite Pixel Teil eines Innenabschnitts eines zusätzlichen Merkmals ist, das auf dem Empfangselement erzeugt wird.

15. Verfahren nach Anspruch 2, worin das erste und zweite Pixel jeweils Teil eines Randabschnitts eines Merkmals sind, das auf dem Empfangselement erzeugt wird.

## Revendications

1. Procédé de formation d'image par transfert thermique comprenant :
l'utilisation d'une tête formatrice d'image pour émettre une pluralité de faisceaux de rayonnement contrôlables individuellement pendant le balayage d'un élément donneur pour former une image sur un élément récepteur ;
l'utilisation d'un canal imageur de la tête formatrice d'image pour émettre un faisceau de rayonnement ayant une première intensité pendant le balayage de l'élément donneur dans une première direction pendant un premier balayage ; et
l'utilisation du canal imageur pour émettre un faisceau de rayonnement ayant une deuxième intensité pendant le balayage de l'élément donneur dans une deuxième direction pendant un deuxième balayage, dans lequel la deuxième direction est opposée à la première direction et la deuxième intensité est différente de la première intensité.

2. Procédé selon la revendication 1, comprenant la formation d'un premier pixel avec le faisceau de rayonnement ayant la première intensité pendant le premier balayage, et la formation d'un deuxième pixel avec le faisceau de rayonnement ayant la deuxième intensité pendant le deuxième balayage.

3. Procédé selon la revendication 2, comprenant la formation du premier pixel avec une première exposition et la formation du deuxième pixel avec une deuxième exposition, dans lequel la deuxième exposition est formée différemment de la première exposition.

4. Procédé selon la revendication 2, comprenant la formation du premier pixel avec une première exposition et la formation du deuxième pixel avec une deuxième exposition, dans lequel la deuxième exposition est supérieure à la première exposition.

5. Procédé selon la revendication 1, dans lequel chacune des première et deuxième intensités est suffisante pour produire une exposition supérieure ou égale à un seuil d'exposition de l'élément donneur pendant chacun des premier et deuxième balayages.

6. Procédé selon la revendication 1, dans lequel chacune des première et deuxième intensités est supérieure à l'intensité de fuite se produisant lorsque le canal imageur n'est pas utilisé pour émettre un faisceau de rayonnement.

7. Procédé selon la revendication 1, comprenant l'établissement d'un mouvement relatif entre la tête formatrice d'image et l'élément récepteur pendant la formation de l'image.

8. Procédé selon la revendication 1, comprenant la sélection d'une première intensité différente de la deuxième intensité.

9. Procédé selon la revendication 1, dans lequel la tête formatrice d'image comprend un modulateur de lumière, le procédé comprenant l'atténuation d'un canal du modulateur de lumière pour rendre la deuxième intensité différente de la première intensité.

10. Procédé selon la revendication 1, dans lequel la tête formatrice d'image comprend un modulateur de lumière, le procédé comprenant la modulation de la durée d'impulsion d'un canal du modulateur de lumière pour rendre la deuxième intensité différente de la première intensité.

11. Procédé selon la revendication 1, comprenant la variation de la puissance fournie au canal imageur pour rendre la deuxième intensité différente de la première intensité.

12. Procédé selon la revendication 2, dans lequel le premier pixel forme une partie d'une portion du contour d'un élément formé sur l'élément récepteur et le deuxième pixel forme une partie d'une autre portion du contour d'un élément formé sur l'élément récepteur.

13. Procédé selon la revendication 2, dans lequel le premier pixel forme une portion intérieure d'un élément formé sur l'élément récepteur et le deuxième pixel forme une portion du contour de l'élément.

14. Procédé selon la revendication 2, dans lequel le premier pixel forme une partie d'une portion du contour d'un élément formé sur l'élément récepteur et dans lequel le deuxième pixel forme une partie d'une portion intérieure d'un élément supplémentaire formé sur l'élément récepteur.

15. Procédé selon la revendication 2, dans lequel chacun des premier et deuxième pixels forme une partie d'une portion du contour d'un élément formé sur l'élément récepteur.
